# EUROPEAN PATENT APPLICATION

(11) **EP 2 610 368 A2**
(43) Date of publication of application: **03.07.2013**
(21) Application number: 12199029.5
(22) Date of filing: 21.12.2012
(51) Int. Cl.: C23C 28/02

(54) **Reflective substrate and method of manufacturing the same**

(30) Priority: 26.12.2011 KR 20110142054
(71) Applicant: Samsung Corning Precision Materials Co., Ltd., Gyeongsangbuk-do Gumi-si, 730-735 (KR)
(72) Inventor: Choi, YongWon, ChungCheongNam-Do 336-841 (KR); Jung, Yung-Jin, ChungCheongNam-Do 336-841 (KR); Moon, Dong-Gun, ChungCheongNam-Do 336-841 (KR); Woo, Kwang-Je, ChungCheongNam-Do 336-841 (KR)
(74) Representative: Gulde Hengelhaupt Ziebig & Schneider

(57) **Abstract**

A reflective substrate, the transmittance of visible light of which is improved, and a method of manufacturing the same. The reflective substrate includes a glass substrate, an oxide or nitride film formed on the glass substrate, and vanadium dioxide (VO₂) film formed on the oxide or nitride film.

## Description

### CROSS REFERENCE TO RELATED APPLICATION

The present application claims priority from Korean Patent Application Number 10-2011-0142054 filed on December 26, 2012, the entire contents of which application are incorporated herein for all purposes by this reference.

### BACKGROUND OF THE INVENTION

### Field of the Invention

The present invention relates to a reflective substrate and a method of manufacturing the same, and more particularly, to a reflective substrate, the transmittance of visible light of which is improved, and a method of manufacturing the same.

### Description of Related Art

Recently, in response to soaring prices of chemical energy sources such as petroleum, the necessity for the development of new energy sources is increasing. In line with the necessity for new energy sources, the importance of energy saving technologies is increasing. In fact, at least 60% of energy consumption in common houses is attributed to heating and/or cooling. In particular, common houses and buildings lose up to 24% of their energy through windows.

Accordingly, various attempts have been made in order to reduce the amount of energy that is lost through windows by increasing the airtightness and insulation characteristics thereof while maintaining the aesthetics and view characteristics, which are the basic functions of windows. Representative methods, by way of example, include varying the size of windows and furnishing high-insulation windows.

Types of high insulation window glass include argon (Ar) injected pair-glass, in which Ar gas or the like is disposed between a pair of glass panes in order to prevent heat exchange, low-e glass, reflective glass, and the like.

Among them, reflective glass is obtained by attaching a thin metal coating on one surface of typical transparent glass, so that the transmittance of light in the visible light range, near infrared (NIR) radiation, and infrared (IR) radiation is reduced. In this way, the reflective glass blocks a significant fraction of sunlight that is radiated thereon from the outside in summer, thereby reducing energy consumption for cooling. In winter, the reflective glass prevents NIR or IR radiation from leaking from the inside of a building, thereby reducing energy consumption for heating.

However, the reflective glass of the related art has drawbacks such as constant transmittance, low visibility due to low transmittance in the visible light range, and the like. In addition, when the reflective glass is designed such that the transmittance of visible light is increased, the unique characteristics of the reflective glass may degrade due to the decreased reflectivity.

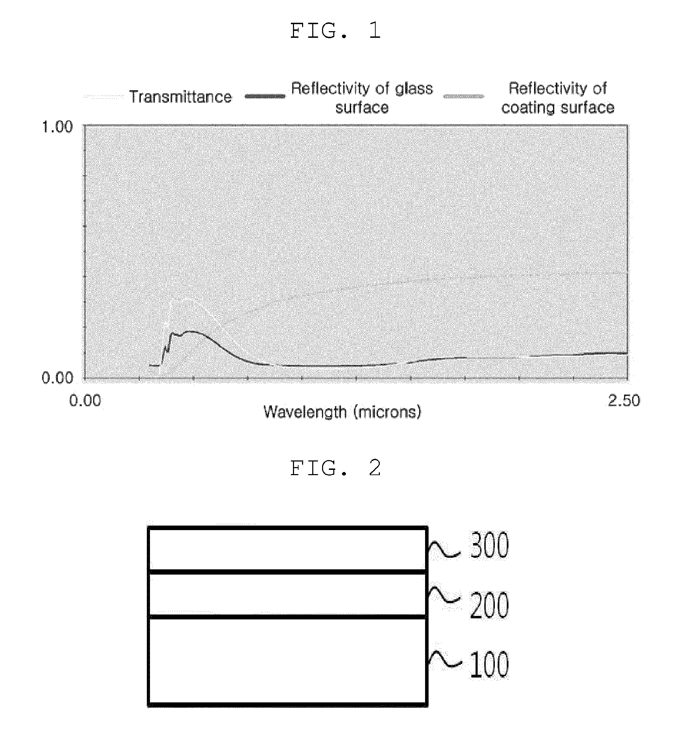

FIG. 1 is a graph depicting the transmittance and reflectivity of reflective glass of the related art. As shown in FIG. 1, it can be appreciated that the transmittance of the reflective glass of the related art in the visible light range is about 30%, and thus visibility is not good. In addition, in the reflective glass of the related art, a coating surface on which a reflective film is coated reflects about 37% of IR radiation, and a glass surface reflects about 5% to 10% of IR radiation. Therefore, it can also be appreciated that the reflectivity of IR radiation, which has a strong thermal action compared to visible light, and ultraviolet (UV) radiation is low.

The information disclosed in this Background of the Invention section is only for the enhancement of understanding of the background of the invention, and should not be taken as an acknowledgment or any form of suggestion that this information forms a prior art that would already be known to a person skilled in the art.

### BRIEF SUMMARY OF THE INVENTION

Various aspects of the present invention provide a reflective substrate, in which the transmittance of visible light and the reflectivity of infrared (IR) radiation are improved, and a method of manufacturing the same.

In an aspect of the present invention, provided is a reflective substrate that includes a base substrate and a thermochromic thin film formed on the base substrate. The thermochromic thin film is made of a thermochromic material doped with a dopant, whereby the phase transition temperature of the thermochromic thin film is lower than the phase transition temperature of the thermochromic material.

In an exemplary embodiment of the invention, the thermochromic material may be one selected from the group consisting of vanadium dioxide (VO₂), titanium oxide (III) (Ti₂O₃), niobium oxide (NbO₂) and nickel sulfide (NiS).

It is preferred that the thermochromic material be VO₂.

Here, the dopant may be one selected from the group consisting of molybdenum (Mo), tungsten (W), chromium (Cr), nickel (Ni) and zirconium (Zr).

It is preferred that the thermochromic thin film may be VO₂ doped with 3at% or more of W.

In an exemplary embodiment of the invention, the reflective substrate may further include an oxide or nitride thin film between the base substrate and the thermochromic thin film.

In an exemplary embodiment of the invention, the oxide or nitride thin film may be made of at least one selected from the group consisting of silicon dioxide (SiO₂), aluminum oxide (Al₂O₃), niobium pentoxide (Nb₂O₅), titanium dioxide (TiO₂), and silicon nitride (Si₃N₄).

It is preferred that the thickness of the oxide or nitride thin film range from 30nm to 80nm.

In another aspect of the present invention, provided is a method of manufacturing a reflective substrate. The method includes the step of forming the thermochromic thin film on the base substrate.

In an exemplary embodiment of the invention, the thermochromic thin film may be formed using a sputtering target that is made of the thermochromic material doped with the dopant, or be formed using both a sputtering target made of the thermochromic material and a sputtering target made of the dopant.

According to embodiments of the invention, it is possible to decrease energy consumption in cooling and heating a building by increasing the reflectivity of IR radiation while increasing visibility by increasing the transmittance of visible light.

The methods and apparatuses of the present invention have other features and advantages which will be apparent from, or are set forth in greater detail in the accompanying drawings, which are incorporated herein, and in the following Detailed Description of the Invention, which together serve to explain certain principles of the present invention.

### BRIEF DESCRIPTION OF THE DRAWINGS

FIG. 1 is a graph depicting the transmittance and reflectivity of reflective glass of the related art;

FIG. 2 is a schematic configuration view of a reflective substrate according to an embodiment of the invention;

FIG. 3 is a graph depicting phase transition temperatures depending on the dose of W that is added to vanadium dioxide (VO₂) ;

FIG. 4 is a graph depicting the transmittances of a VO₂ thin film; and

FIG. 5 is a schematic flowchart depicting a method of manufacturing reflective glass according to an embodiment of the invention.

### DETAILED DESCRIPTION OF THE INVENTION

Reference will now be made in detail to a reflective substrate and a method of manufacturing the same according to the present invention, various embodiments of which are illustrated in the accompanying drawings and described below, so that a person having ordinary skill in the art to which the present invention relates can easily put the present invention into practice.

Throughout this document, reference should be made to the drawings, in which the same reference numerals and signs are used throughout the different drawings to designate the same or similar components. In the following description of the present invention, detailed descriptions of known functions and components incorporated herein will be omitted when they may make the subject matter of the present invention unclear.

FIG. 2 is a schematic configuration view of a reflective substrate according to an embodiment of the invention.

Referring to FIG. 2, the reflective substrate of this embodiment such as a reflective glass, may include a glass substrate 100, an oxide or nitride thin film 200 and a vanadium dioxide (VO₂) thin film.

The glass substrate 100 is a transparent or colored substrate that has a predetermined area and a predetermined thickness. It is preferred that the glass substrate 100 be made of sodalime glass.

The oxide or nitride thin film 200 is formed on the glass substrate 100, and acts as a sodium diffusion barrier to prevent sodium (Na) ions in the glass substrate from diffusing into the VO₂ thin film 300, which will be described later, at temperatures of 350°C or higher in the process of manufacturing the reflective substrate. Otherwise, the VO₂ thin film 300 would lose its thermochromic characteristics due to the sodium diffusion.

The oxide or nitride thin film 200 may be made of one material selected from among, but not limited to, silicon dioxide (SiO₂), niobium pentoxide (Nb₂O₅), aluminum oxide (Al₂O₃), titanium dioxide (TiO₂) , and silicon nitride (Si₃N₄) . Although it is preferred that the thickness of the oxide or nitride thin film 200 range from 30nm to 80nm, the thickness may vary depending on the type of materials on which a coating is to be formed, the refractivity of coating materials, and the like.

The VO₂ thin film 300 is formed on the oxide or nitride thin film 200, and undergoes phase transition depending on the temperature, thereby adjusting the transmittance of infrared (IR) radiation.

The transition of the VO₂ thin film 300 occurs at a predetermined temperature, at which the crystalline structure of VO₂ changes due to the thermochromic phenomenon, so that the physical properties (electrical conductivity and infrared radiation transmittance) of the VO₂ thin film drastically change. As a result, the VO₂ thin film 300 blocks near IR radiation and IR radiation while allowing visible light to pass through.

The VO₂ thin film 300 may be doped with a dopant in order to reduce the phase transition of VO₂, which is typically 68°C. It is preferred that the VO₂ thin film be doped with at least one selected from among molybdenum (Mo), tungsten (W), chromium (Cr), nickel (Ni) and zirconium (Zr).

It is preferred that the VO₂ thin film 300 be made of VO₂ that is doped with 3at% or more of W. When VO₂ is doped with 3at% of W, the phase transition temperature of the VO₂ thin film 300 is lowered to about 30°C, and is lowered further with increasing doses of W.

In this way, it is possible to ensure that the phase transition temperature of the VO₂ thin film become lower than room temperature by adjusting the dose of the dopant, so that the VO₂ thin film can block sunlight in the NIR and IR ranges at room temperature and the transmittance of visible light of the VO₂ thin film can remain constant.

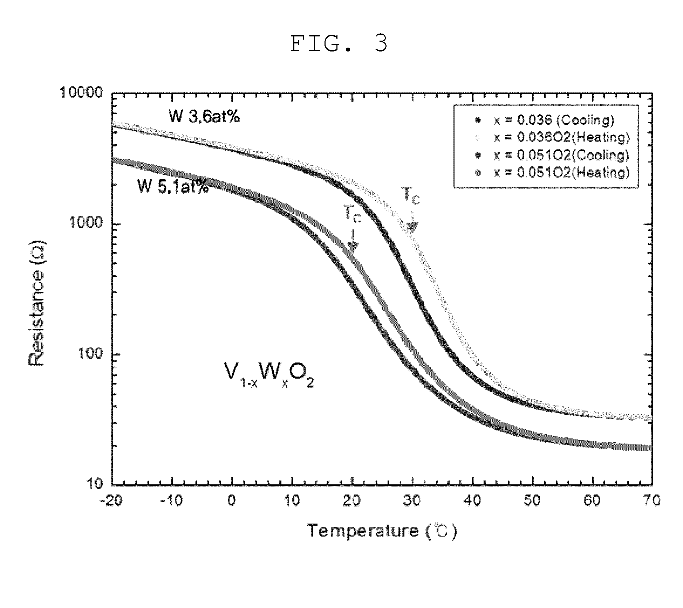

FIG. 3 is a graph depicting phase transition temperatures depending on the dose of W that is added to VO₂.

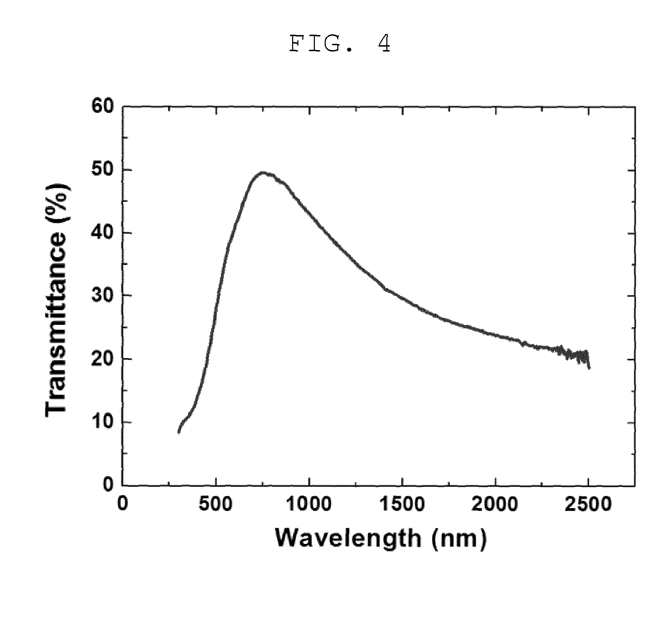

Referring to FIG. 3, it can be appreciated that the resistance varies depending on the dose of W that is added. Since the semiconducting properties of VO₂ prior to phase transition are converted into metallic properties after the phase transition, it is possible to determine the temperature at which the phase transition of VO₂ occurs based on a change in the resistance of VO₂. As shown in FIG. 4, the phase transition temperature of the VO₂ thin film is 30°C when VO₂ is doped with 3.6at% of W, and is 20°C when VO₂ is doped with 5.1at% of W.

In this way, the VO₂ thin film formed on the glass substrate makes it possible to improve the characteristics of reflective substrate by increasing the reflection of IR radiation while improving visibility by increasing the transmittance of visible light.

FIG. 4 is a graph depicting the transmittances of a VO₂ thin film.

Referring to FIG. 4, it can be appreciated that the VO₂ thin film has a transmittance of about 50% in the visible light range and a transmittance of about 30% or less in the IR range. It is apparent that the reflective substrate of the invention exhibits excellent characteristics, such as excellent visibility, owing to the fact that transmittance of visible light is higher than that of the reflective substrate of the related art, and high reflectivity in the IR range.

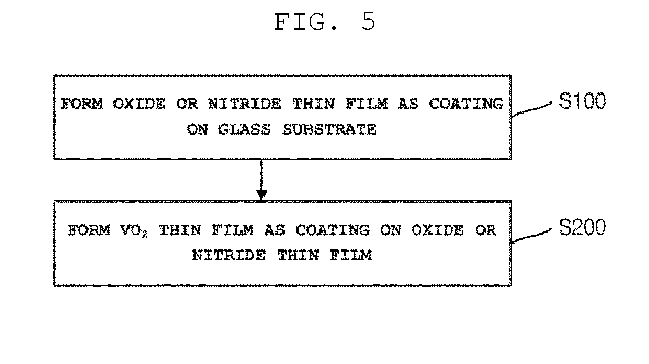

FIG. 5 is a schematic flowchart depicting a method of manufacturing reflective substrate according to an embodiment of the invention.

Referring to FIG. 5, the method of manufacturing the reflective substrate of this embodiment may include the following steps of: forming an oxide or nitride thin film as a coating on a glass substrate (S100) and forming a VO₂ thin film as a coating on the oxide or nitride thin film via sputtering deposition (S200).

Here, the oxide or nitride thin film, which is made of one material selected from among silicon dioxide (SiO₂), niobium pentoxide (Nb₂O₅), aluminum oxide (Al₂O₃), titanium dioxide (TiO₂), and silicon nitride (Si₃N₄), may be formed via reactive sputtering deposition.

In addition, the VO₂ thin film may be formed via sputtering deposition using a sputtering target made of VO₂ that is doped with at least one substance selected from among Mo, W, Cr, Ni and Zr, or co-sputtering deposition using a sputtering target made of VO₂ and a sputtering target made of at least one substance selected from among Mo, W, Cr, Ni and Zr.

The foregoing descriptions of specific exemplary embodiments of the present invention have been presented with respect to the certain embodiments and drawings. They are not intended to be exhaustive or to limit the invention to the precise forms disclosed, and obviously many modifications and variations are possible for a person having ordinary skill in the art in light of the above teachings.

It is intended therefore that the scope of the invention not be limited to the foregoing embodiments, but be defined by the Claims appended hereto and their equivalents.

## Claims

1. A reflective substrate comprising:
a base substrate; and
a thermochromic thin film formed on the base substrate,
wherein the thermochromic thin film comprises a thermochromic material and a dopant doped into the thermochromic material such that a phase transition temperature of the thermochromic thin film is lower than a phase transition temperature of the thermochromic material.

2. The reflective substrate of claim 1, wherein the thermochromic material comprises one selected from the group consisting of vanadium dioxide (VO₂), titanium oxide (III) (Ti₂O₃), niobium oxide (NbO₂) and nickel sulfide (NiS).

3. The reflective substrate according to one of the preceding claims, wherein the thermochromic material comprises vanadium dioxide (VO₂), and
wherein the dopant comprises one selected from the group consisting of molybdenum (Mo), tungsten (W), chromium (Cr), nickel (Ni) and zirconium (Zr).

4. The reflective substrate of claim 3, wherein the thermochromic thin film comprises the vanadium dioxide (VO₂) doped with 3at% or more of the tungsten (W).

5. The reflective substrate according to one of the preceding claims, further comprising an oxide or nitride thin film between the base substrate and the thermochromic thin film.

6. The reflective substrate of claim 5, wherein the oxide or nitride thin film comprises at least one selected from the group consisting of silicon dioxide (SiO₂), aluminum oxide (Al₂O₃) niobium pentoxide (Nb₂O₅), titanium dioxide (TiO₂), and silicon nitride (Si₃N₄).

7. The reflective substrate according to one of claims 5 and 6, wherein a thickness of the oxide or nitride thin film ranges from 30nm to 80nm.

8. A method of manufacturing a reflective substrate comprising forming a thermochromic thin film according to one of the preceding claims on the base substrate.

9. The reflective substrate of claim 8, wherein the thermochromic thin film is formed using a sputtering target that comprises the thermochromic material doped with the dopant.

10. The reflective substrate according to one of claims 8 and 9, wherein the thermochromic thin film is formed using a sputtering target that comprises the thermochromic material and a sputtering target that comprises the dopant.
